## Europäisches Patentamt
## European Patent Office
## Office européen des brevets

(19)

(11) Veröffentlichungsnummer: **0 019 667**
B1

(12)

# EUROPÄISCHE PATENTSCHRIFT

(45) Veröffentlichungstag der Patentschrift:
10.03.82

(51) Int. Cl.³: **F 16 B 19/02**, G 09 F 9/35

(21) Anmeldenummer: 79200276.8

(22) Anmeldetag: 05.06.79

(54) Befestigungseinrichtung für eine Flüssigkristallanzeige auf einer Trägerplatte.

(43) Veröffentlichungstag der Anmeldung:
10.12.80 Patentblatt 80/25

(45) Bekanntmachung des Hinweises auf die Patenterteilung:
10.03.82 Patentblatt 82/10

(84) Benannte Vertragsstaaten:
**CH DE FR GB**

(56) Entgegenhaltungen:
**DD-A-66 048**
**DE-A-1 500 833**
**DE-A1-2 558 497**
**DE-A1-2 722 388**
**DE-U-6 908 401**
**DE-U-7 019 161**
**FR-A1-2 361 687**
**FR-A1-2 379 087**
**GB-A-1 291 990**
**US-A-3 139 784**
**US-A-4 025 162**

(73) Patentinhaber: **BBC Aktiengesellschaft Brown, Boveri & Cie., CH-5401 Baden (CH)**

(72) Erfinder: **Fehlmann, Erich, Heimentalstrasse 35, CH-5430 Wettingen (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

Befestigungseinrichtung für eine Flüssigkristallanzeige auf einer Trägerplatte

Die vorliegende Erfindung betrifft eine Befestigungseinrichtung für eine Flüssigkristallanzeige auf einer Trägerplatte mit mindestens einem Verbindungselement, das einen zum Einstecken in eine Bohrung in der Trägerplatte vorgesehenen Schaft und einen zum Andrücken an die Oberfläche der Flüssigkristallanzeige vorgesehenen, als abgekröpfter Haken ausgebildeten Kopf aufweist und mindestens einem zum elastischen Andrücken der Flüssigkeitsanzeige an die Trägerplatte und zum elektrisch leitenden Verbinden der Kontakte oder Leiter auf der Trägerplatte mit den zugeordneten Kontakten der Flüssigkristallanzeige geeigneten, geschichteten Kontaktelement.

Flüssigkristallanzeigen werden gewöhnlich auf einer Trägerplatte befestigt, auf der zugleich die Zuleitungen für die elektrischen Signale angeordnet sind. Zum elektrisch leitenden Verbinden dieser Zuleitungen mit den entsprechenden Elektrodenkontakten werden geschichtete, elastische Kontaktelemente verwendet. Dabei ist zu beachten, daß die Anzeige verschiebungsfest gehalten ist, um eine sichere Kontaktierung zu gewährleisten und die Halterung nachgiebig genug ist, um ein Verbiegen oder Verspannen der Anzeige zu vermeiden. Üblicherweise werden dazu Kunststoffrahmen verwendet, in die die Anzeige eingelegt wird und die dann auf der Trägerplatte befestigt werden. Solche Rahmen sind beispielsweise in der DE-A1-2 558 497 und der FR-A1-2 379 087 beschrieben. Damit ein Rahmen eine genaue Positionierung der Flüssigkristallanzeige gewährleistet, müssen seine Abmessungen genau auf diejenigen der betreffenden Anzeige abgestimmt sein und der Rahmen selbst verschiebungsfest auf der Trägerplatte befestigt werden. Dazu ist für jeden Anzeigentyp ein zugeordneter Rahmen erforderlich, was mit relativ hohen Herstellungs- und Lagerhaltungskosten verbunden ist, und das Befestigen des Rahmens auf der Trägerplatte wird zu einem aufwendigen und darum kostspieligen Arbeitsgang.

Aus anderen Bereichen der Technik sind schon Befestigungselemente bekannt, die zum Befestigen von Bauteilen mit unterschiedlichen Abmessungen verwendet werden können. Beispielsweise ist in der DD-A 66 048 ein Klemm-Spanndübel für das Befestigen von Zierleisten an Fahrzeugkarosserien beschrieben. Dieser Dübel enthält einen abgekröpften, hakenförmigen Kopf zum Einschieben in die Zierleiste und einen mit Haftrippen versehenen Schaft zum Eindrücken in eine Bohrung der Karosserie. Ein ähnlicher Dübel, der für praktisch den gleichen Zweck vorgesehen ist, ist in der US-A-3 139 784 beschrieben. Schließlich ist aus dem DE-U-6 908 401 eine zweiteilige Verbindungsvorrichtung bekannt mit einer zum Befestigen an einem Werkstück vorgesehenen Buchse und einem Haltebolzen, der durch ein anderes Werkstück gesteckt und in die Buchse eingesteckt werden kann.

Diese Befestigungselemente gewährleisten bestimmungsgemäß eine sehr rigide Halterung der Bauteile und sind für das Befestigen von Flüssigkristallanzeigen auf einer Trägerplatte nicht geeignet.

Der vorliegenden Erfindung liegt darum die Aufgabe zugrunde, eine Befestigungseinrichtung zu schaffen, welche für Flüssigkristallanzeigen mit beliebigen Abmessungen verwendbar ist, billig hergestellt werden kann und mit der eine Flüssigkristallanzeige in einem einfachen Arbeitsgang und ohne störende Verspannung zu erzeugen, auf einer Trägerplatte befestigt werden kann.

Erfindungsgemäß wird diese Aufgabe mit einer Befestigungseinrichtung der eingangs genannten Art gelöst, die dadurch gekennzeichnet ist, daß der Schaft des Verbindungselements zum Verhindern einer Verschiebung in der die Befestigung der Flüssigkristallanzeige lösenden Richtung mit elastischen Zungen versehen ist, deren der Schaftspitze zugewandtes Ende am Schaft angeordnet und deren dem Kopf zugewandtes Ende zum Abspreizen und federnden Anlegen an die Rückseite der Trägerplatte vorgesehen ist.

Bei einer bevorzugten Ausführungsform der neuen Befestigungseinrichtung ist ein zusätzliches, zum Aufschieben auf den Schaft des Verbindungselements und zum Anlegen an die dem Kopf abgewandte Fläche der Printplatte geeignetes Halteelement vorgesehen.

Die neue Befestigungseinrichtung benötigt nur ein Verbindungselement, das zum Befestigen von allen Ausführungsformen von Flüssigkristallanzeigen und unabhängig von deren Form und Abmessungen verwendet werden kann. Das neue Befestigungselement ist darum auch für Prototypen- und Kleinserien geeignet, für die die Kosten für ein Kunststoffspritzgußwerkzeug nicht gerechtfertigt sind. Das neue Befestigungselement kann mit relativ großen Toleranzen und darum sehr billig hergestellt und ohne besonderes manuelles Geschick verwendet werden.

Nachfolgend wird ein Ausführungsbeispiel der Erfindung mit Hilfe der Figuren beschrieben. Es zeigt

Fig. 1 die schematische, perspektivische Ansicht einer Printplatte mit ausgelegten, geschichteten Kontaktelementen und einer angehobenen Flüssigkristallanzeige,

Fig. 2 den Schnitt durch einen Teil einer Flüssigkristallanzeige, die mit einem Rahmen auf einer Printplatte befestigt ist,

Fig. 3 die perspektivische Ansicht einer Ausführungsform des neuen Verbindungselements und die Seitenansicht eines Halteelements und

Fig. 4 den Schnitt durch eine Flüssigkristallanzeige, die mit Hilfe der neuen Verbindungselemente auf einer Printplatte befestigt ist.

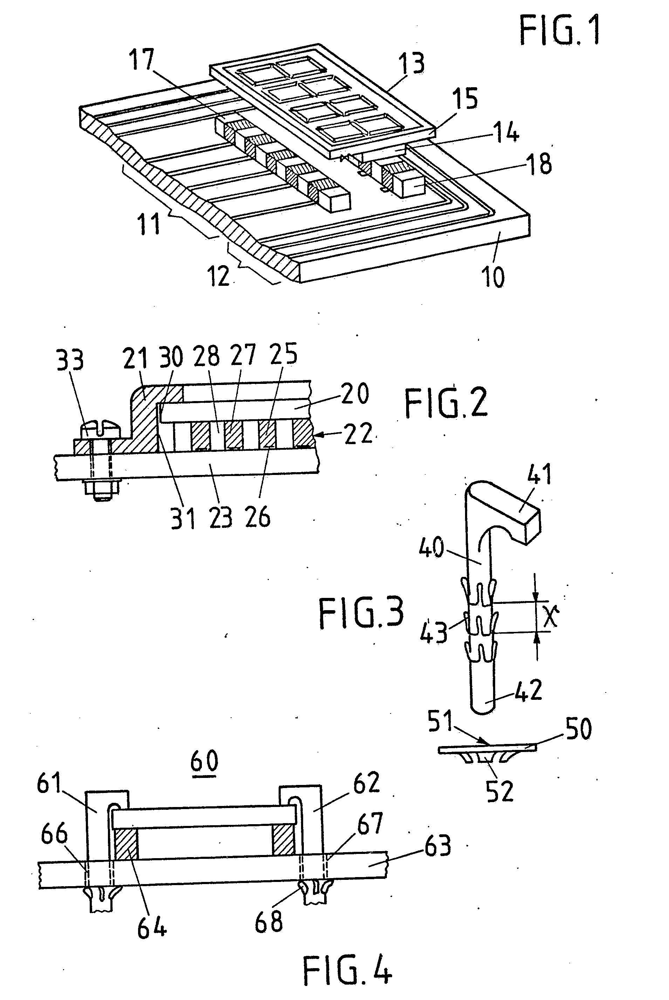

In Fig. 1 ist ein Teil einer Printplatte 10 gezeigt, auf der zwei metallische Leitergruppen 11, 12 aufgebracht sind. Solche Printplatten sind jedem Fachmann bekannt, weshalb auf deren detaillierte Beschreibung verzichtet wird. Über der Printplatte ist eine Flüssigkristallanzeige 13 gezeichnet, welche der Einfachheit wegen nur vier Ziffern aufweist. Diese Anzeige enthält eine kleinere, zum Aufsetzen auf die Printplatte vorgesehene Glasplatte 14 und eine darüberliegende größere Glasplatte 15. Auf den der Printplatte zugewandten Flächen der überstehenden Ränder der größeren Glasplatte sind (nicht gezeigte) Zuleitungen für die Elektroden angeordnet. Auf jeder Leitergruppe liegt ein geschichteter Kontaktelement 17, 18. Solche Kontaktelemente bestehen aus einem im gezeigten Beispiel liegenden Stapel von elektrisch leitfähigen Lamellen aus Silikonkautschuk, die von Lamellen aus elektrisch isolierendem Silikonkautschuk getrennt sind. Beim Auflegen der Flüssigkristallanzeige auf die Kontaktelemente werden die Elektrodenzuleitungen mit den Leitergruppen elektrisch leitend verbunden. Dabei versteht sich, daß für die vorgesehene Zuordnung von Leiter und Elektrodenzuleitung nur die Ausrichtung der Flüssigkristallanzeige gegenüber dem Leiter bzw. der Leitergruppe wichtig ist, während es ohne Bedeutung ist, welche leitfähige Lamelle des Kontaktelements die elektrische Leitung bewirkt. Die Kontaktelemente wurden speziell für die beschriebene Verwendung entwickelt und sind unter der Bezeichnung »Interconnectoren« handelsüblich.

Fig. 2 zeigt den Schnitt durch einen Teil einer Flüssigkristallanzeige 20, die in der bisher gebräuchlichen Weise mit Hilfe eines passenden Rahmens 21 unter Zwischenlage eines Kontaktelements 22 auf einer Printplatte 23 befestigt ist. Auf der Unterseite der größeren oberen Glasplatte sind die Elektrodenzuleitungen zu erkennen (z. B. die Zuleitung 25) und auf der Oberseite der Printplatte die Leiter (z. B. der Leiter 26). Weiter sind deutlich die elastisch leitenden und die isolierenden Lamellen (z. B. die Lamellen 27 bzw. 28) des Kontaktelements 22 zu unterscheiden. Der Abstand zwischen den Seitenflächen (z. B. der Fläche 30) und den entsprechenden Innenflächen (z. B. der Fläche 31) des Rahmens 21 ist kleiner als der seitliche Abstand zwischen den Elektrodenzuleitungen bzw. den Leitern auf der Printplatte, damit die geforderte gegenseitige Zuordnung gewährleistet ist. Der Rahmen ist mit mindestens zwei Schrauben, von denen in der Figur nur die Schraube 33 gezeigt ist, an der Printplatte befestigt. Die Innenhöhe des Rahmens, d. h. die Höhe der Fläche 31, ist etwas und beispielsweise 0,1 mm kleiner als die Dicke des Kontaktelements 22 und der oberen Glasplatte der Flüssigkristallanzeige, so daß beim Verschrauben des Rahmens das federnde Kontaktelement zusammengedrückt wird und ein guter elektrischer Kontakt gesichert ist.

In Fig. 3 ist eine Ausführungsform des neuen Verbindungselements gezeigt. Diese Ausführungsform weist einen Schaft 40 auf, an dessen oberem Ende ein abgekröpfter Kopf 41 angeformt ist. Das untere Ende 42 des Schafts ist verrundet. Längs des Schafts sind eine Vielzahl Zungen 43 angeordnet, deren dem unteren Ende 42 des Schafts zugewandtes Ende am Schaft befestigt ist und deren dem Kopf 41 zugewandtes Ende zum Abspreizen vorgesehen ist. Bei der gezeigten Ausführungsform sind die Zungen auf Umfangskreisen 44 des Schafts befestigt. Der axiale Abstand x der Umfangskreise entspricht etwa der Dicke einer Glasplatte der Flüssigkristallanzeige und beispielsweise 1 mm. Das Verbindungselement ist vorzugsweise aus einem schlagfesten elastischen Kunststoff hergestellt. Bei einer weiteren bevorzugten Ausführungsform sind die Zungen direkt am Schaft angeformt.

Weiter ist in Fig. 3 ein als Federscheibe ausgebildetes Halteelement 50 gezeigt. Die Federscheibe weist eine mittlere Bohrung 51 auf, deren Durchmesser etwas größer als die Dicke des Schafts 40 ist. Der Rand der Bohrung ist in bekannter Weise mit radialen Schlitzen versehen, die zum Ausbiegen vorgesehene Lappen 52 seitlich begrenzen.

Fig. 4 zeigt analog zur Fig. 2 den Schnitt durch einen Teil einer Flüssigkristallanzeige 60, die mit den neuen Verbindungselementen 61, 62 auf einer Printplatte 63 befestigt ist. Zwischen den Elektrodenzuleitungen auf der unteren Seite der oberen Glasplatte der Flüssigkristallanzeige und den Leitungen auf der Printplatte ist ein geschichtetes elastisches Kontaktelement 64 eingelegt.

Bei der Verwendung der neuen Befestigungseinrichtung werden zuerst die Kontaktelemente 64 auf die Printplatte 63 aufgelegt und danach die Flüssigkristallanzeige 60 auf diese Kontaktelemente. Dann werden mindestens zwei Verbindungselemente 61, 62 durch Bohrungen 66, 67 in der Printplatte gesteckt. Die Köpfe der Verbindungselemente drücken dabei auf die Oberseite der Flüssigkristallanzeige, und die an dem auf der Unterseite der Printplatte herausragenden Teil des Schafts angeordneten und abgespreizten Zungen legen sich an die Printplatte an und verhindern dadurch das Zurückgleiten des Verbindungselements. Auf diese Weise kann die Flüssigkristallanzeige mit schwachem Druck an die Printplatte angedrückt werden, wobei der abgekröpfte Kopf und die Zungen des Verbindungselements ebenso wie das elastische Kontaktelement die Druckkraft erzeugen. Wahlweise kann auf der Unterseite der Printplatte auch eine Federscheibe verwendet werden, insbesondere wenn die Bohrung für das Halteelement so groß ist, daß die freien Enden der Zungen sich nicht mit Sicherheit an die Platte anlegen können.

Zur sicheren Ausrichtung der Flüssigkristallanzeige auf der Printplatte und insbesondere der Elektrodenzuleitungen zu den Leitungen auf der Platte können auf der Printplatte ein oder mehrere Anschläge, beispielsweise in der Form eines Lötpunkts, vorgesehen werden.

Wie die praktische Erfahrung gezeigt hat, ist die Reibungskraft zwischen der Flüssigkristallanzeige und dem elastischen Kontaktelement bzw. zwischen diesem Element und der Printplatte so groß, daß sich die mit der neuen Befestigungseinrichtung befestigten Flüssigkristallanzeigen auch bei starken mechanischen Beschleunigungen, langdauernden Erschütterungen oder Schlägen nicht verschiebt.

Es versteht sich, daß die neue Verbindungseinrichtung auch anders als im gezeigten Ausführungsbeispiel ausgeführt werden kann. Beispielsweise kann das Verbindungselement an Stelle des abgekröpften Kopfes einen tellerförmigen Kopf aufweisen. Weiter ist es möglich, die Zungen nicht auf voneinander beabstandeten Umfangskreisen, sondern auf einer längs des Schafts verlaufenden Schraubenlinie anzuordnen. Es ist auch möglich, den Schaft konisch auszubilden und ohne die Hilfe von Zungen in einer Bohrung der Printplatte durch einen Preßsitz zu halten.

Die Bohrungen zum Einsetzen des neuen Verbindungselements können eine relativ große Toleranz, sowohl bezüglich ihres Durchmessers als auch bezüglich des Abstands von den aufgedruckten Leitern oder Kontakten aufweisen und zusammen mit den zum Befestigen von anderen Schaltelementen erforderlichen Bohrungen in die Platte gebohrt werden.

Bezeichnungsliste

| | | |
|---|---|---|
| 10 | = | Printplatte |
| 11, 12 | = | Leitergruppen |
| 13 | = | Flüssigkristallanzeige |
| 14, 15 | = | Glasplatten |
| 17, 18 | = | Kontaktelemente |
| 20 | = | Flüssigkristallanzeige |
| 21 | = | Rahmen |
| 22 | = | Kontaktelement |
| 23 | = | Printplatte |
| 25 | = | Zuleitung |
| 26 | = | Leiter |
| 27, 28 | = | Lamellen |
| 30, 31 | = | Flächen |
| 33 | = | Schraube |
| 40 | = | Schaft |
| 41 | = | Kopf |
| 42 | = | unteres Schaftende |
| 43 | = | Zungen |
| 44 | = | Umfangskreise |
| 50 | = | Halteelement |
| 51 | = | Bohrung |
| 52 | = | Lappen |
| 60 | = | Flüssigkristallanzeige |
| 61, 62 | = | Verbindungselemente |
| 63 | = | Printplatte |
| 64 | = | Kontaktelement |
| 66, 67 | = | Bohrungen |

## Patentansprüche

1. Befestigungseinrichtung für eine Flüssigkristall-Anzeige auf einer Trägerplatte, mit mindestens einem Verbindungselement, das einen zum Einstecken in eine Bohrung in der Trägerplatte vorgesehenen Schaft und einen zum Andrücken an die Oberfläche der Flüssigkristall-Anzeige vorgesehenen, als abgekröpfter Haken ausgebildeten Kopf aufweist, und mindestens einem zum elastischen Andrücken der Flüssigkeitsanzeige an die Trägerplatte und zum elektrisch leitenden Verbinden der Kontakte oder Leiter auf der Trägerplatte mit den zugeordneten Kontakten der Flüssigkristall-Anzeige geeigneten, geschichteten Kontaktelement, dadurch gekennzeichnet, daß der Schaft (40) des Verbindungselements (61, 62) zum Verhindern einer Verschiebung in der Befestigung der Flüssigkristall-Anzeige (60) lösenden Richtung mit elastischen Zungen (43, 68) versehen ist, deren der Schaftspitze (42) zugewandtes Ende am Schaft angeordnet und deren dem Kopf (41) zugewandtes Ende zum Abspreizen und federnden Anlegen an die Rückseite der Trägerplatte (63) vorgesehen ist.

2. Befestigungseinrichtung nach Anspruch 1, dadurch gekennzeichnet, daß die Zungen (43) längs einer Schraubenlinie am Schaft (40) angeordnet sind.

3. Befestigungseinrichtung nach Anspruch 1, dadurch gekennzeichnet, daß die Zungen (43) längs mehrerer in axialer Richtung voneinander beabstandeter Umfangslinien am Schaft (40) angeordnet sind.

4. Befestigungseinrichtung nach Anspruch 1, weiter gekennzeichnet durch ein zum Aufschieben auf den Schaft (40) und zum Anlegen an die dem Kopf (41) abgewandte Fläche der Printplatte (63) vorgesehenes Halteelement (50).

5. Befestigungseinrichtung nach Anspruch 4, dadurch gekennzeichnet, daß das Halteelement eine Federscheibe (50) ist.

## Claims

1. Device for securing a liquid crystal display on a carrier-plate, this device having at least one connecting element which posesses a shaft, provided for the purpose of insertion into a hole drilled in the carrierplate, and a head, designed in the form of a cranked hook and provided for the purpose of pressing into contact with the surface of the liquid crystal display, and having at least one coated contact element suitable for the purpose of resiliently pressing the liquid crystal display into contact with the carrier-plate and for connecting, in an electrically conducting manner, the contacts or conductors on the carrier-plate with the associated contacts of the liquid crystal display, characterised in that the shaft (40) of the connecting element (61, 62) is provided with resilient tongues (43, 68) for the purpose of preventing any shifting in the direction which releases the attachment of the liquid crystal display (60), the ends of these tongues facing the tip (42) of the shaft being located on the shaft, and the ends of the tongues facing the head (41) being provided for the purpose of splaying out and resiliently bearing on the rear side of the carrier-plate (63).

2. Securing device according to Claim 1, characterised in that the tongues (43) are located along a helical line on the shaft (40).

3. Securing device according to Claim 1, characterised in that the tongues (43) are located along a plurality of circumferential lines on the shaft (40), which are spaced from one another in the axial direction.

4. Securing device according to Claim 1, additionally characterised by a retaining element (50), provided for the purpose of being pushed onto the shaft (40) and for bearing against that surface of the printed circuit board (63) which faces away from the head (41).

5. Securing device according to Claim 4, characterised in that the retaining element is a spring washer (50).

**Revendications**

1. Dispositif de fixation pour un dispositif d'affichage à cristaux liquide sur une plaque de support comportant au moins un élément d'assemblage qui présente une tige prévue pour être insérée dans une forure dans la plaque de support et une tête ayant la forme d'un crochet décalé prévue pour exercer une pression sur la surface du dispositif d'affichage à cristaux liquides, ainsi qu'au moins un élément de contact stratifié propre à presser élastiquement le dispositif d'affichage à cristaux liquide sur la plaque de support et à connecter électriquement les contacts ou les conducteurs sur la plaque de support aux contacts associés du dispositif d'affichage à cristaux liquides, caractérisé en ce que la tige (40) de l'élément d'assemblage (61, 62) est pourvue, en vue d'empêcher un déplacement dans le sens du desserrage de la fixation du dispositif d'affichage à cristaux liquides (60), de languettes élastiques (43, 68) dont l'extrémité tournée vers la pointe (42) de la tige est fixée à celle-ci et dont l'extrémité tournée vers la tête (41) est conçue pour s'épanouir et s'appliquer élastiquement contre la face postérieure ou l'envers de la plaque de support (63).

2. Dispositif de fixation suivant la revendication 1, caractérisé en ce que les languettes (43) sont disposées sur la tige (40) suivant une ligne hélicoïdale.

3. Dispositif de fixation suivant la revendication 1, caractérisé en ce que les languettes (43) sont disposées sur la tige (40) suivant plusieurs lignes périphériques espacées les unes des autres dans le sens axial.

4. Dispositif de fixation suivant la revendication 1, caractérisé par un élément de retenu (50) prévu pour être glissé sur la tige (40) et pour venir s'appliquer contre la surface de la plaque à circuits imprimés (63) opposée à la tête (41).

5. Dispositif de fixation suivant la revendication 4, caractérisé en ce que l'élément de retenue est une rondelle de ressort (50).

0 019 667

FIG.1

FIG.2

FIG.3

FIG.4